Europäisches Patentamt

European Patent Office

Office européen des brevets

(19)

(11) Veröffentlichungsnummer : **0 301 161 B1**

(12) **EUROPÄISCHE PATENTSCHRIFT**

(45) Veröffentlichungstag der Patentschrift :
**18.01.95 Patentblatt 95/03**

(51) Int. Cl.⁶ : **H03M 13/12**

(21) Anmeldenummer : **88102529.0**

(22) Anmeldetag : **22.02.88**

(54) **Verfahren zur Aufbereitung eines Faltungscodes zur Übertragung sowie dessen empfangsseitige Rückwandlung sowie Anordnung hierzu.**

(30) Priorität : **25.07.87 DE 3724729**

(43) Veröffentlichungstag der Anmeldung :
**01.02.89 Patentblatt 89/05**

(45) Bekanntmachung des Hinweises auf die
Patenterteilung :
**18.01.95 Patentblatt 95/03**

(84) Benannte Vertragsstaaten :
**DE FR GB IT**

(56) Entgegenhaltungen :
**GB-A- 2 095 517**

(56) Entgegenhaltungen :
**CONF PROCEEDINGS OF THE 7TH INT CONF
ON DIGITAL SATELLITE COMMUNICATIONS
23 September 1983, NEW-YORK, NY, US Seiten 1224 - 1231; YUTAKA YASUDA ET
AL:"DEVELOPMENT OF VARIABLE-RATE VI-
TERBI DECODER AND ITS PERFORMANCE
CARACTERISTICS"**

(73) Patentinhaber : **ANT Nachrichtentechnik
GmbH
Gerberstrasse 33
D-71522 Backnang (DE)**

(72) Erfinder : **Enders, Peter, Dipl.-Ing.(FH)
Karl-Krische-Strasse 4
D-7150 Backnang (DE)**
Erfinder : **Heichler, Johannes, Dipl.-Ing.(FH)
Haselweg 8
D-7157 Murrhardt 3 (DE)**

**Beschreibung**

Verfahren zur Aufbereitung eines Faltungscodes zur Übertragung sowie dessen empfangsseitigen Rückwandlung sowie Einrichtung hierzu

Die Erfindung geht aus von einem Verfahren gemäß dem Oberbegriff des Patentanspruchs 1. Ein solches Verfahren ist bekannt aus Conference Proceedings of the 6th International Conference on Digital Satellite Communications, Phoenix, Arizona, USA, Sept. 1983, Seite XII/24-31.

Faltungscodes hoher Rate lassen sich prinzipiell auf zwei Arten erzeugen:

a) durch Verwendung eines Encoders hoher Rate,

b) durch Anwendung einer Code-Punktierung auf einen Code niedriger Rate.

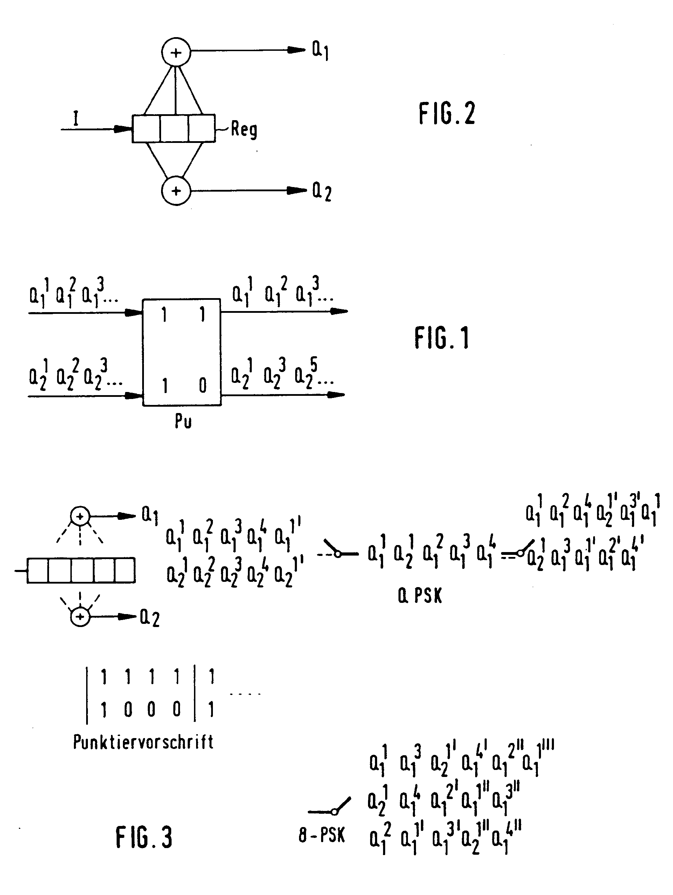

Bei der Code-Punktierung werden bei einem Faltungscode niedriger Rate in periodischen Abständen einzelne Bits ausgeblendet. Figur 1 gibt das Prinzip einer solchen Punktierung wieder. Die Quellbits I werden in das Register Reg des Encoders - Figur 2 - eingeschrieben. Die Ausgangsbitströme Q1 und Q2 des Encoders werden über Summierer abgenommen, die Parallelausgänge der Registerzellen miteinander verknüpfen. Ein Punktierer Pu, der sich durch eine Punktierungsvorschrift beschreiben läßt, unterdrückt jene Bits, für die die Vorschrift eine 0 aufweist und überträgt jene Bits, für die die Vorschrift eine 1 aufweist. Blendet man von einem Code der Rate 1/2 jedes vierte Bit aus, entsteht ein Code der Rate

$$1/2 \cdot 4/3 \ = \ 2/3 \quad \text{(Fig. 1)}.$$

Punktierte Codes können decodiert werden wie der ursprünglich unpunktierte Code der Rate 1/n, d.h. für jeden State muß nur eine Auswahl aus zwei (statt $2^{n-1}$) möglichen Pfaden getroffen werden. Empfangsseitig ist für einen punktierten Code vor dem Decoder ein Depunktierer vorgesehen, mittels dessen an Stelle der zuvor ausgeblendeten Bits sog. "Dummy-Bits" eingeblendet werden, die auf die Metrikrechnung keinen Einfluß haben (Seite XII/25, 1. Spalte vorgenannter Veröffentlichung).

Aus IEEE Transactions on Communications, Vol. COM-32, No. 3, März 1984, Seiten 315-319, ist es bekannt, Faltungscodes höherer Rate durch Punktierung von einem Code der Rate 1/2 abzuleiten, wobei die Rate auch variabel sein kann.

Aus der GB-A-2095517 ist ein Fehlerkorrekturverfahren für ein digitales Übertragungssystem bekannt, welches die "Maximum Likelihood" Fehlerkorrekturmethode benutzt. Der Coder besteht dort aus einem Schieberegister zur Aufbereitung eines konvolutionell codierten Datenstromes, einem nachgeschalteten Parallel-Serien-Wandler und einem FIFO-Speicher zur Zwischenspeicherung der Daten für Übertragung. Der Lesetakt dieses FIFO-Speichers wird über einen Speicher gesteuert, der dafür sorgt, daß einige Symbole im Ausgangsdatenstrom des Coders ausgelassen werden können, um die Codierrate zu erhöhen. Auf der Empfangsseite ist für den Decoder ein Speicher vorgesehen, über welchen anstelle der ausgelassenen Symbole "Dummy Bits" eingefügt werden. Außerdem sind auf der Empfangsseite Serien-Parallel-Wandler vorgesehen, die der Stufe zur Metrikberechnung vorgeschaltet sind. Gleichartige Baugruppen enthält auch der aus vorgenannter Veröffentlichung: Conference Proceedings of the 6th International Conference on Digital Comminations .... bekannte Codec.

Aufgabe der Erfindung ist es, das Verfahren ausgehend vom Oberbegriff des Patentanspruchs 1 so auszubilden, daß eine leichtere Phasenfehlerkorrektur auf der Empfangsseite möglich ist. Außerdem soll eine Einrichtung zur Aufbereitung eines Faltungscodes hoher Rate angegeben werden mittels deren ebenfalls eine leichtere Phasenfehlerkorrektur möglich ist. Die Aufgabe wird bezüglich des Verfahrens durch die Merkmale des Patentanspruchs 1 und bezüglich der Einrichtung durch die Merkmale des Patentanspruchs 2 gelöst. Die Ansprüche 3 bis 13 zeigen Ausgestaltungen der Einrichtung auf.

Das Verfahren bzw. die Einrichtung gemäß der Erfindung besitzt folgende Vorteile:

Durch die Parallelverarbeitung bei der Punktierung und der Depunktierung ist eine höhere Verarbeitungsgeschwindigkeit erreichbar. Durch die erfindungsgemäße Datenumordnung läßt sich die Verzögerungszeit zwischen der Phasenfehlerkorrektur und der Metrikberechnung im Decoder verkürzen und damit die Synchronisationszeit verringern. Ein solcher Coderatenwechsel ist bei Verschlechterung einer Satelliten-Übertragungsstrecke oft erforderlich. Da alle n Übertragungskanäle durch die Verteilung gemäß der Erfindung die gleiche Periodendauer aufweisen, ist eine bessere Synchronisations-Fehlerkorrigierbarkeit möglich. Die Punktierungsvereinbarung bleibt als Ganzes erhalten, da die Daten immer aus den gleichen Zeitintervallen pro Kanal zusammengesetzt sind. Dies führt ebenfalls zu einer besseren Phasen-Fehlerkorrekturmöglichkeit, im Gegensatz zur Realisierung gemäß 6th Internat. Conference on Digital Satellite Communications Proceedings, wo die Verteilung der Übertragungsdaten auf die Kanäle willkürlich ist. Beim Verfahren nach der Erfindung ergibt sich eine geordnete Struktur, die der PSK-Übertragung angepaßt ist und daher eine einfache Fehlerkorrektur gestattet. Mehrdeutige Phasenfehler (Phaseambiguity) können durch einfache Kanalvertauschung korrigiert werden.

EP 0 301 161 B1

Anhand der Zeichnungen wird die Erfindung nun näher erläutert. Es zeigen

Fig. 3  die sendeseitigen Bitströme bei herkömmlicher Übertragung,

Fig. 4  die sendeseitigen Bitströme bei Verfahren nach der Erfindung,

Fig. 5  die herkömmliche Depunktierung,

Fig. 6  die Depunktierung nach der Erfindung,

Fig. 7  eine Übersicht einer Anordnung zum Durchführen des Verfahrens nach der Erfindung,

Fig. 8  einen sendeseitigen Datenumordner,

Fig. 9  einen weiteren sendeseitigen Datenumordner,

Fig. 10  die Erzeugung der Schreibtakte für die Datenumordner gemäß den Figuren 8 und 9,

Fig. 11  einen sendeseitigen Datenumordner für die Rate R = 1/3,

Fig. 12  einen weiteren sendeseitigen Datenumordner für die Rate R = 1/3,

Fig. 13  die Erzeugung der Schreibtakte für die Datenumordner gemäß den Figuren 12 und 13,

Fig. 14  das Prinzip eines Parallel-Punktierers,

Fig. 15  das Prinzip eines Parallel-Depunktierers,

Fig. 16  einen empfangsseitigen Datenumordner,

Fig. 17  einen weiteren empfangsseitigen Datenumordner,

Fig. 18  die Erzeugung der Lesetakte für die empfangsseitigen Datenumordner,

Fig. 19  einen aus einer Schieberegisterbank bestehenden empfangsseitigen Datenumordner,

Fig. 20  die Kanalvertauschung bei Phaseambiguity,

Fig. 21 bis 23  die Verläufe von Steuersignalen für verschiedene Phasenzustände,

Fig. 24  den Aufbau der Steuerstufe für die Steuersignale,

Fig. 25  eine Modifikation der Schieberegisterbank,

Fig. 26  eine Schieberegisterbank für n-PSK mit Busausgang,

Fig. 27  die Erzeugung von Steuersignalen für n-PSK,

Fig. 28  den Verlauf der Steuersignale bei n-PSK.

Bei der Übertragung mit einem Faltungscode der Rate R = 4/5 punktiert aus einem Code der Rate R = 1/2 ergibt sich die in Fig. 3 aufgezeigte Ungleichverteilung der Daten auf die beiden Kanäle, wenn man die Ausgangsbitströme $Q_1$ und $Q_2$ des Encoders pro Periode unter Berücksichtigung der Punktiervorschrift (Deleting map) zuerst serialisiert - $Q_1^1 Q_2^1 Q_1^3 Q_1^4$ - und anschließend für die Übertragung wieder parallelisiert. Fig. 3 zeigt in der oberen Reihe die Verteilung der Daten für eine QPSK-Übertragung und in der unteren Reihe die Verteilung für 8-PSK.

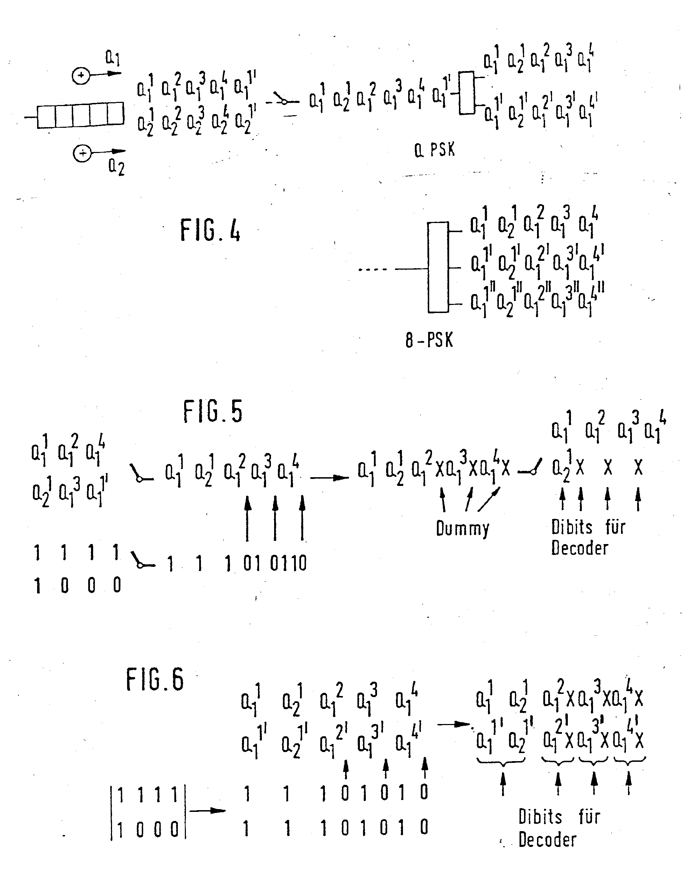

Beim Verfahren nach der Erfindung wird ebenfalls serialisiert, jedoch nicht wie in Figur 3 wieder parallelisiert, sondern auf den zweiten Kanal kommt durch die Parallelverarbeitung die gleich aufgebaute Periode aus dem nächsten Zeitintervall ($Q_x'$). Figur 4 zeigt die eingangs- und ausgangsseitigen Bitströme bei der Verarbeitung gemäß der Erfindung. Bei QPSK-Übertragung enthält der obere Kanal nur ungestrichene Quellbits, d.h. alle Quellbits stammen aus dem durch die Periodendauer festgelegten Zeitintervall. Der untere Kanal enthält nur gestrichene Quellbits, die alle aus dem nächstfolgenden Zeitintervall stammen. Auf jeden Kanal gelangt immer die gleiche Anzahl Quellbits - Gleichverteilung. Bei der 8-PSK-Übertragung sind die entsprechenden Verhältnisse darunter dargestellt. Alle Kanäle enthalten die gleichen Quellbits. Die zu Fig. 3 gehörige herkömmliche Depunktierung auf der Empfangsseite ist in Fig. 5 dargestellt. Da keine Gleichverteilung der Bits bezüglich der Kanäle vorliegt, müssen in einen Kanal mehr Bits - neutrale "Dummy Bits X" - eingefügt werden als in den anderen Kanal. Es muß erneut serialisiert und wieder parallelisiert werden, um Dibits für den Decoder zu erzeugen. Beim Verfahren nach der Erfindung hingegen sind die Datenströme bezüglich der Kanäle gleich verteilt und gleich aufgebaut. Die Depunktierung kann daher für alle Kanäle parallel und gleichzeitig vorgenommen werden (Fig. 6).

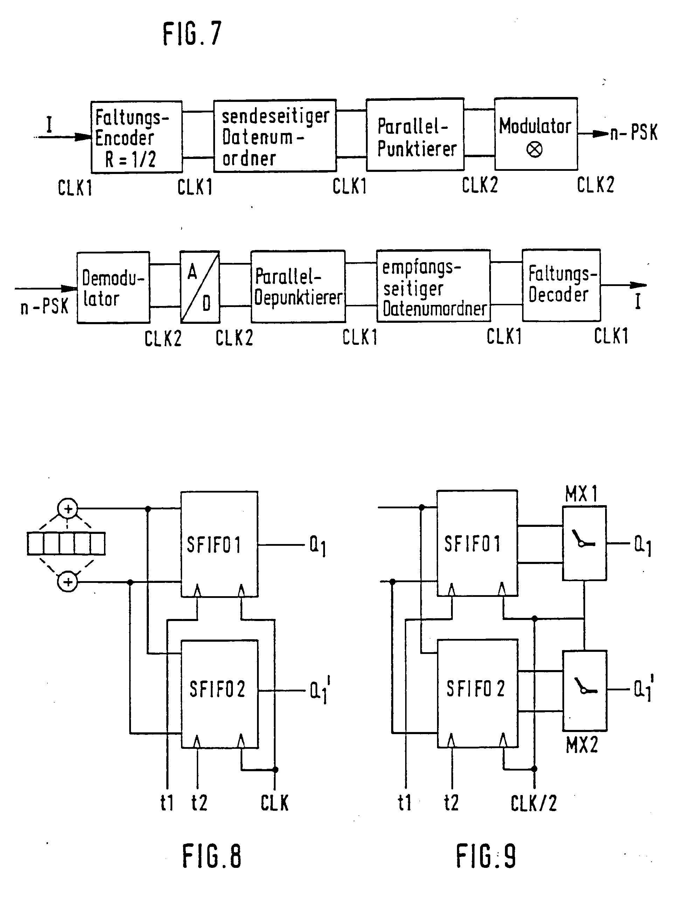

Figur 7 zeigt eine Übersicht einer Anordnung zum Durchführen des Verfahrens nach der Erfindung. Der Quellbitstrom I wird einem Faltungs-Encoder zugeführt. An den Faltungs-Encoder schließt sich ein sendeseitiger Datenumordner an, dem ein Parallel-Punktierer nachgeschaltet ist. Ein Modulator zur Aufbereitung eines zu übertragenden n-PSK-Signals erhält die Ausgangsdatenströme des Parallel-Punktierers. Empfangsseitig ist ein Demodulator zur Demodulation des n-PSK-Signals vorgesehen, gefolgt von einem Analog-/Digitalwandler. Diesem ist ein Parallel-Depunktierer und ein empfangsseitiger Datenumordner nachgeschaltet. Ein sich anschließender Faltungs-Decoder, z.B. ein Viterbi-Decoder, dient zur Rückwandlung der Daten entsprechend den auf der Sendeseite eingegebenen Quelldaten. In Figur 7 ist vor jeder Verarbeitungsstufe der Takt CLK1, bzw. CLK2 eingetragen. Die Verarbeitungsstufen Encoder, Decoder, Modulator, Demodulator und A/D-Wandler werden nachfolgend nicht weiter behandelt, da sie durch bekannte Standardschaltungen realisierbar sind. In diesem Zusammenhang sei beispielsweise auf die Veröffentlichungen NTC, Vol. 3, 1981, E. 1.7.1. - E. 1.7.4. und Conference Proceedings of the 7th International Conference on Digital Satellite Communications, München, 1986, Seiten 361 - 367, verwiesen. Die übrigen Verarbeitungsstufen werden nun erläutert.

Am Beispiel einer Datenrate von R = 1/2 wird der sendeseitige Datenumordner anhand der Figuren 8 und 9 erläutert. Die mit dem Takt CLK in die Registerzellen des Encoders ENC eingeschriebenen Quellbits werden, wie bereits geschildert, über Summierer miteinander verknüpft. Die Ausgangssignale der Summierer werden zwei elastischen FIFO-Speichern SFIFO1 und SFIFO2 parallel zugeführt. In diese Speicher sind die Encoderausgangssignale für jeweils eine volle Periode P über ihren Schreibtakt t1, bzw. t2 abwechselnd einlesbar. Das Auslesen der Daten erfolgt kontinuierlich - gemeinsamer Lesetakt CLK. Damit wird der gewünschte zeitliche Versatz erreicht. Beim Ausführungsbeispiel gemäß Fig. 8 sind die Speicher SFIFO1 und SFIFO2 parallel-seriell wandelnd ausgebildet. Sie haben demzufolge jeweils nur einen Datenausgang. Beim Ausführungsbeispiel gemäß Fig. 9 sind die Speicher SFIFO1 und SFIFO2 parallel-parallel wandelnd ausgebildet. Die jeweils zwei Ausgangsbitströme pro Speicher werden über einen nachgeschalteten Multiplexer MX1 bzw. MX2 als Mittel zur Parallel-Serienwandlung geführt. Der Schreibtakt für jeden Speicher ist wie beim Ausführungsbeispiel gemäß Fig. 8 t1 bzw. t2. Der gemeinsame Lesetakt ist jedoch in Abweichung zum Ausführungsbeispiel gemäß Fig. 8 nur CLK/2. Als Steuersignal für die Fortschaltung der Multiplexer MX1 und MX2 dient ebenfalls CLK/2.

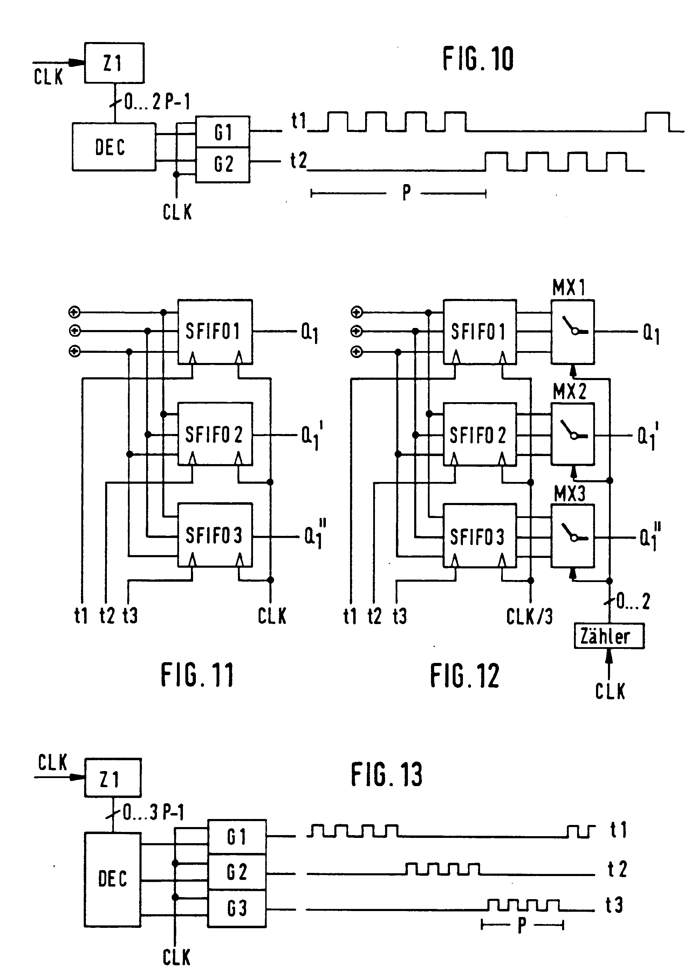

Den Datenumordnern gemäß den Figuren 8 und 9 sind gleich aufgebaute Steuerschaltkreise zugeordnet zur Erzeugung der Schreibtakte t1 und t2 (Fig. 10). Diese Steuerschaltkreise bestehen aus einem Zähler Z1 zum Zählen der Impulse des von einem Generator gelieferten Taktes CLK. Über einen Decoder DEC ist der Ausgang des Zählers Z1 mit zwei parallel angeordneten &-Gattern G1, G2 verbunden. Diesen &-Gattern wird der Takt CLK ebenfalls zugeführt. Am Ausgang des &-Gatters G1 erscheint der Schreibtakt t1 während der ersten Periode der Dauer P und der Schreibtakt t2 während der zweiten Periode der Dauer P. Der Vorteil der Datenumordnung nach der Erfindung liegt darin, daß obwohl die Daten in den einzelnen Kanälen seriell gewandelt werden, keine schnelleren Takte auftreten als die Informationsbitrate. Es handelt sich also um eine sehr schnelle, echte Parallelverarbeitung. Außerdem ist das Verfahren flexibel. Ein Übergang auf einen Quellcode der Rate 1/n bedeutet lediglich, daß die elastischen Speicher statt zwei n Paralleleingänge haben. Der Übergang auf ein n-kanaliges Übertragungssystem bedeutet, daß statt zwei n elastische Speicher parallel verwendet werden.

Die Figuren 11 bis 13 zeigen als Beispiel Datenumordner mit den zugehörigen Steuerschaltkreisen für einen Code der Rate R = 1/3 und 8 PSK-Modulation. Bei den Datenumordnern gemäß den Figuren 11 und 12 arbeiten 3 elastische FIFO-Speicher SFIFO1, SFIFO2, SFIFO3 parallel. In Fig. 11 sind diese Speicher wie in Fig. 8 parallel-seriell wandelnd ausgebildet und in Fig. 12 parallel-parallel wandelnd mit nachgeschalteten Multiplexern MX1, MX2, MX3 zur Parallel-Serienwandlung. Die Lesetakte t1, t2 und t3 werden durch Steuerschaltkreise erzeugt, die denen von Fig. 13 entsprechen, d.h. Decoder DEC jetzt mit 3 Ausgängen und 3 nachgeschalteten parallel arbeitenden &-Schaltungen. Es ergeben sich um jeweils eine Periodendauer P versetzte Schreibtakte t1, t2 und t3. Der Lesetakt ist bei Fig. 11 wieder CLK und bei Fig. 12 CLK/3.

Punktiert und depunktiert wird in allen Kanälen gleichzeitig. Auch hier ist der schnellste Takt die Informationsbitrate. Anders als bei herkömmlichen seriellen Verfahren kann bei der Erfindung die höhere Kapazität von 4- oder 8-PSK Systemen durch Parallelverarbeitung in einen Geschwindigkeitsgewinn umgesetzt werden.

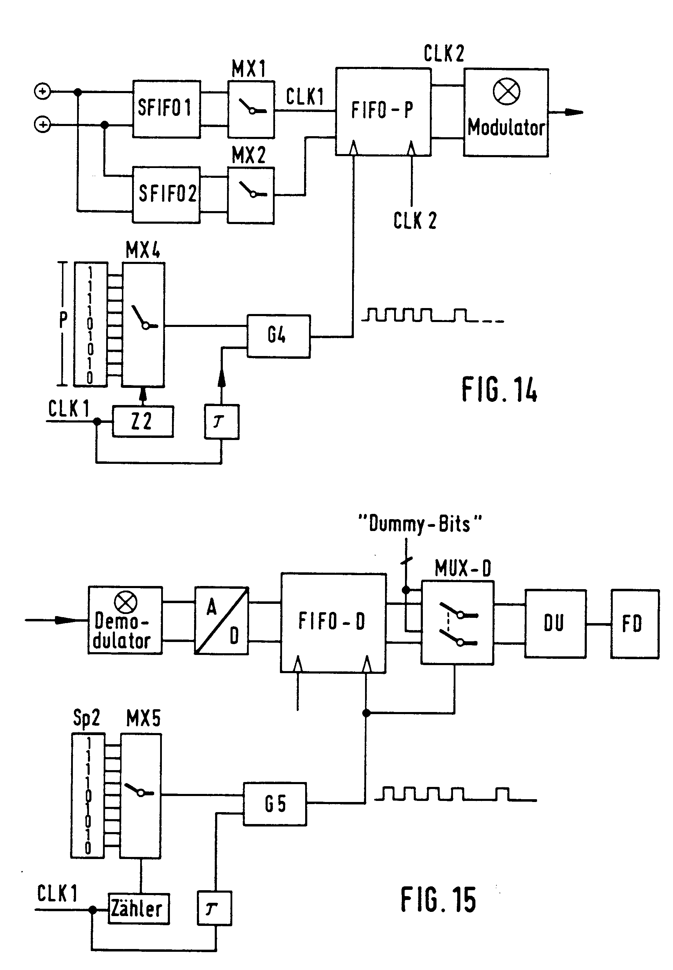

Fig. 14 zeigt das Prinzip eines Parallel-Punktierers FIFO-P, dem beispielsweise der Datenumordner gemäß Fig. 9 vorgeschaltet ist. Für den Parallel-Punktierer FIFO-P kann ein handelsüblicher integrierter Schaltkreis, beispielsweise ein TDC 1030 der Firma TRW verwendet werden. Es wird ein Schreibtakt zugeführt, der für die auszulassenden - punktierten - Bits eine Unterbrechung aufweist. Diese Schreibtaktunterbrechung wird durch ein &-Gatter G4 erreicht, dem zum einen ein kontinuierlicher Takt CLK1 zugeführt wird und zum anderen das Ausgangssignal eines Multiplexers MX4. Dieser Multiplexer MX4 schaltet das in einem Speicher Sp1 abgelegte Punktiermuster (Deleting Map) mit der Breite P Bits auf das Gatter G4 durch. Sobald der Multiplexer MX4 von der Deleting Map eine 0 auf das Gatter G4 durchschaltet, wird der Schreibtakt unterbrochen. Der Multiplexer MX4 wird in seiner Fortschaltung über einen Zähler Z2 vom Takt CLK1 gesteuert. Zur Unterdrückung von Spikes ist das Gatter G4 nicht direkt mit dem Takt CLK1 beaufschlagt, sondern mit einem durch ein Verzögerungsglied etwas verzögerten Takt, der die Umschaltzeiten des Multiplexers MX4 berücksichtigt. Der Lesetakt CKL2 für den Parallel-Punktierer ist kontinuierlich. Die grunsätzliche Funktion des Punktierers ist ähnlich wie in Conf. Proc. 6th Internat. Conf. on Digital Satellite Communications, Seite XII-26, Fig. 5, jedoch ist die Verarbeitung parallel und damit bei gleicher Taktrate der doppelte Datendurchsatz erreichbar.

Der empfangsseitige Depunktierer FIFO-D ist in Fig. 15 dargestellt. Die mittels Demodulator demodulierten Empfangsdaten werden A/D gewandelt und dem Eingang des elastischen Speichers FIFO-D zugeführt. Der empfangsseitige Depunktierer ist analog zum sendeseitigen Punktierer aufgebaut, also ebenfalls parallel verarbeitend. Nur wird beim Punktierer der FIFO-Schreibtakt unterbrochen bei kontinuierlichem Lesetakt, und beim Depunktierer wird der FIFO-Schreibtakt CLK2 kontinuierlich zugeführt und der Lesetakt CLK1 unterbrochen. Die Unterbrechung des Lesetaktes wird wie die Unterbrechung des Schreibtaktes auf der Sendeseite realisiert, also mittels &-Gatter G5, dem zum einen ein kontinuierlicher Takt CLK1 zugeführt wird und zum an-

4

deren das Ausgangssignal eines Multiplexers MX5. Dieser Multiplexer MX5 schaltet das in einem Speicher Sp2 abgelegte Depunktiermuster auf das Gatter G5 durch. Dem Depunktierer FIFO-D ist ein Multiplexer MUX-D nachgeschaltet, der in die Lesepausen des FIFO-D metrikneutrale Auffülldaten "Dummy-Bits", beispielsweise Daten aus der Wertebereichsmitte einer Soft-Decision Decodierung, einblendet. An den Multiplexer MUX-D schließt sich ein empfangsseitiger Datenumordner DU und ein Faltungs-Decoder FD an. Verschiedene Ausführungsformen für einen solchen empfangsseitigen Datenumordner werden nun beschrieben.

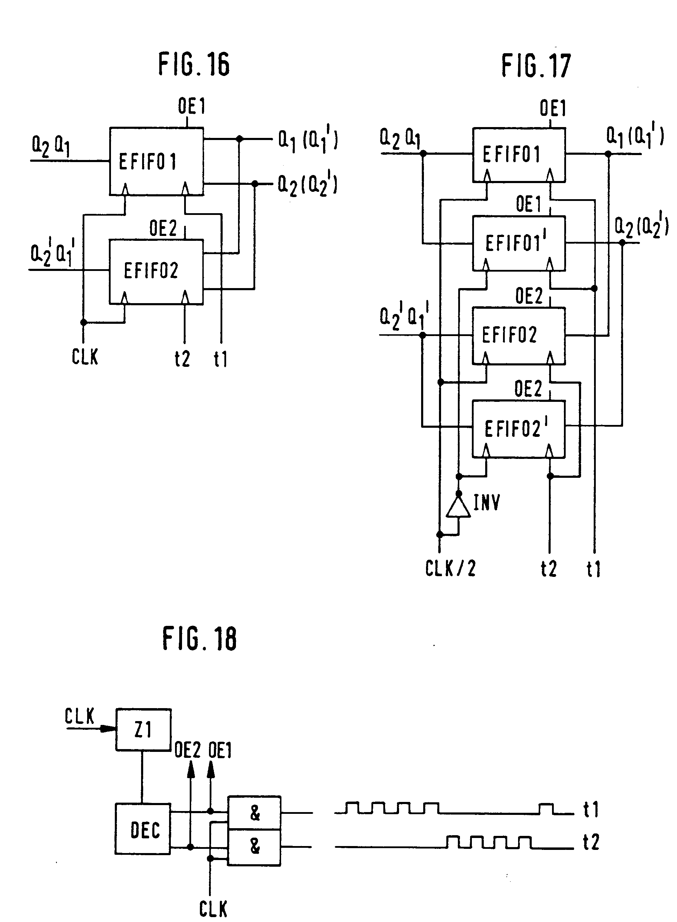

Entsprechend den sendeseitigen Datenumordnern sind auch auf der Empfangsseite solche Datenumordner vorgesehen. In den Figuren 16 und 17 sind empfangsseitige Datenumordner vorgesehen, die von ihrer Struktur her den sendeseitigen Datenumordnern gemäß den Figuren 8 und 9 entsprechen. Die Datenumordner nach Fig. 16 bestehen für eine Datenrate R = 1/2 aus zwei elastischen FIFO-Speichern EFIFO1 und EFIFO2, die seriell-parallel wandelnd ausgebildet sind. Ihre Ausgänge sind parallel geschaltet. An ihren Eingängen liegen die Kombinationen aufeinanderfolgender Bits verschiedener Perioden $Q_2 Q_1$, $Q_2' Q_1'$ an. Der zeitliche Versatz wird durch die FIFO-Speicher erreicht, in die nun kontinuierlich eingelesen und abwechselnd ausgelesen wird, so daß an den Ausgängen der Datenumordner parallel und gleichzeitig die Bits gleicher Perioden-Dibit-Kombinationen anliegen. Der Schreibtakt CLK ist für beide FIFO-Speicher gleich. Die gegeneinander versetzten Lesetakte t1 und t2 werden, wie Fig. 18 zeigt, mit ähnlichen Steuerschaltkreisen wie in Fig. 10 erzeugt - Zähler Z1, Decoder DEC, &-Gatter. Die Ausgangssignale des Decoders werden als Output-Enable-Signale OE1 und OE2 an die entsprechenden Eingänge der FIFO-Speicher gelegt.

Fig. 17 zeigt einen weiteren empfangsseitigen Datenumordner. Er arbeitet mit seriellen FIFO-Speichern. Die Seriell-Parallel-Wandlung wird bei einer Rate R = 1/2 durch zwei FIFO-Speicher EFIFO1, EFIFO1', bzw. EFIFO2, EFIFO2' pro Kanal erreicht, in die abwechselnd eingelesen wird. Der Schreibtakt für die beiden FIFO-Speicher eines Kanals ist einmal CLK/2 und einmal CLK/2 invertiert.

Zur Schreibtaktinvertierung ist der Inverter INV vorgesehen. Die mit dem gleichen Schreibtakt beaufschlagten FIFO-Speicher sind ausgangsseitig zusammengeschaltet. Damit wird folgende Umordnung realisiert:
Die aufeinanderfolgenden Bit-Kombinationen $Q_2 Q_1$ werden in die parallel vorliegende Dibit-Kombination $Q_1$ und $Q_2$ aufgespalten, ebenso die aufeinanderfolgende Bit-Kombination $Q_2' Q_1'$ der nächsten Periode in die Dibit-Kombination $Q_1'$ und $Q_2'$.

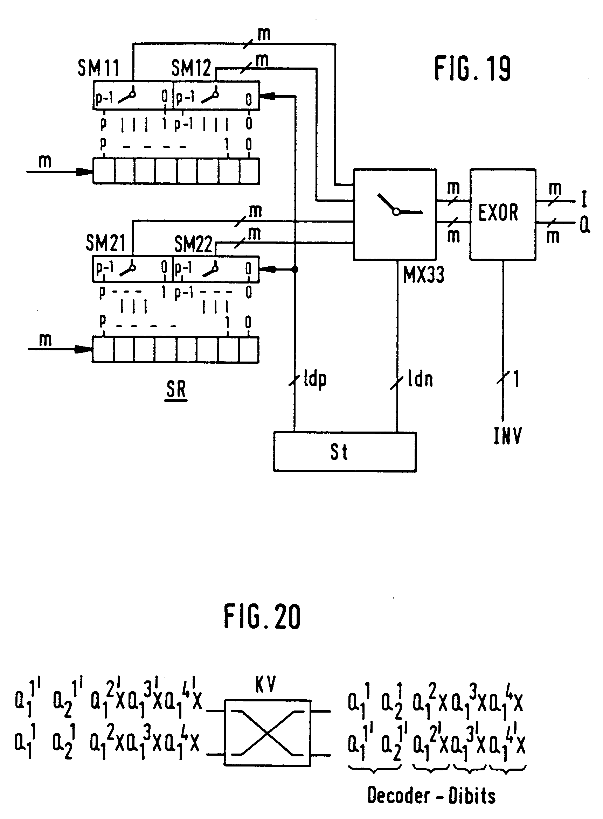

Fig. 19 zeigt eine Alternativlösung für den empfangsseitigen Datenumordner. Der Datenumordner besteht hier aus einer Schieberegisterbank SR, deren Breite durch die Anzahl n der Kanäle der Soft Decision Wortbreite und deren Länge durch die Anzahl der Bits pro Periode P +1 gegeben ist. Zur Seriell-Parallel-Wandlung sind für jede Registerzeile zwei Multiplexer SM11, SM12; SM21, SM22 vorgesehen, die jeweils mit den Parallelausgängen der Schieberegisterbank SR verbunden sind. Sie werden von einer Steuerschaltung St gegenläufig und bezüglich der Parallelausgänge der Schieberegisterbank SR um eine Registerzelle versetzt gesteuert. Es entstehen dadurch m Dibits - Soft Decision Bits -, so daß die Übertragungsdaten wieder in der ursprünglichen zeitlichen Folge vorliegen. Aus der Schieberegisterbank werden so immer zwei Bits ausgelesen, während nur eines eingelesen wird. Die Anzahl der Steuerleitungen für die Fortschaltung der Multiplexer beträgt ld P. Bei der Verwendung der Schieberegisterbank in Verbindung mit den Multiplexern verkürzt sich die Durchlaufzeit durch den Parallelzugriff gegenüber den FIFO-Speichern gemäß den Figuren 16 und 17. An den Ausgängen der Schieberegisterbank SR befindet sich ein weiterer Multiplexer MX33, der nach jeder Periode ein anderes Schieberegister an seinen Ausgang schaltet. Die Anzahl der Steuerleitung für die Fortschaltung dieses Multiplexers MX33 beträgt ld n.

Eine Korrektur einer Phasenmehrdeutigkeit "Phaseambiguity Korrektur" des empfangenen n-PSK-Signals ist bei dem Verfahren nach der Erfindung noch hinter dem Depunktierer oder dem empfangsseitigen Datenumordner möglich, im Gegensatz zu herkömmlichen Realisierungen, wo die zusammengehörigen Dibits hinter dem Depunktierer nicht mehr übereinander liegen und eine Phaseambiguity-Korrektur dort nicht mehr durch Invertieren und/oder Vertauschen der Kanäle zu lösen ist. Wenn man die Phaseambiguity-Korrektur hinter dem empfangsseitigen Datenumordner vornimmt, erreicht man den Vorteil, daß zwischen Korrektur und der Decodierung durch den Faltungsdecoder keine synchronisationszeitverlängernden Laufzeiten mehr auftreten können.

Die Phaseambiguity-Korrektur ist insbesondere bei einer Code-Punktierung wichtig. Da durch die Punktierung dem Code eine periodische Struktur überlagert ist, ist bei punktierten Codes eine Codesynchronisation erforderlich. Diese ist abhängig von der Coderate. Z.B. muß für einen Code der Rate $5/X^2$ eine 5-fache Mehrdeutigkeit gelöst werden, für einen Code der Rate $6/X^2$ eine 6-fache usw. Vergrößert man die Punktierungsperiode um einen Faktor K, z.B. für einen Code der Rate $\dfrac{k \cdot 5}{k \cdot x}$, so ist auch eine k·5 fache Mehrdeutigkeit zu lösen.

Fig. 20 zeigt die Kanalvertauschung mittels einer Kanalvertauschungsstufe KV bei Auftreten von Phaseambiguity.

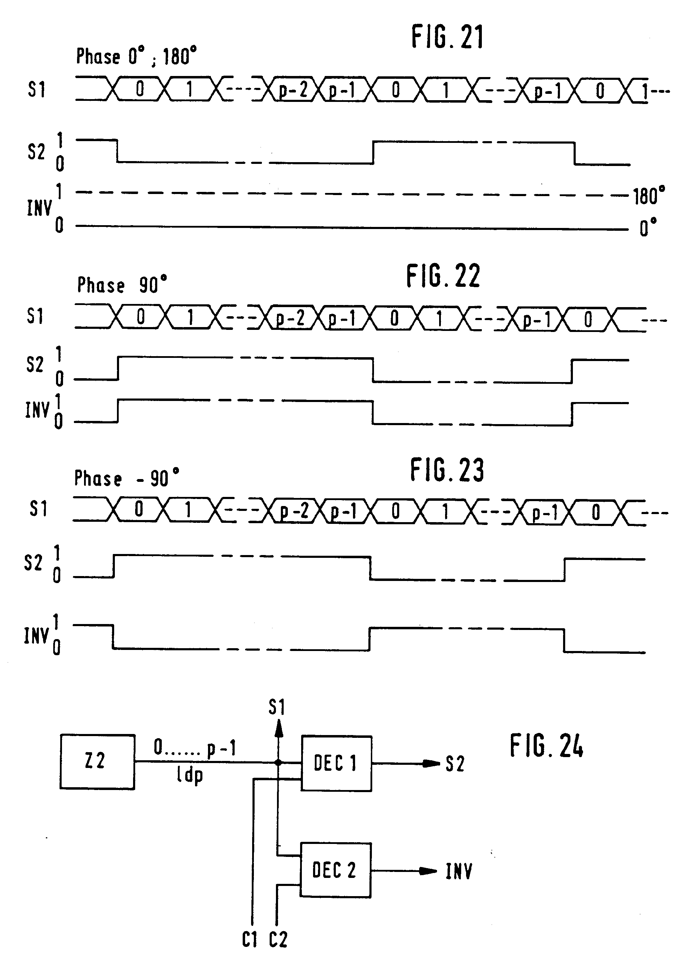

Beim Ausführungsbeispiel gemäß Fig. 19 ist zur Phaseambiguity-Korrektur ein schaltbarer Inverter - EXOR-Gatter - vorgesehen, dessen Umschalten durch das Steuersignal INV ausgelöst wird. Die Verläufe der Steuersignale S1, S2 und INV für die verschiedenen Phasenzustände zeigen die Figuren 21 bis 23.

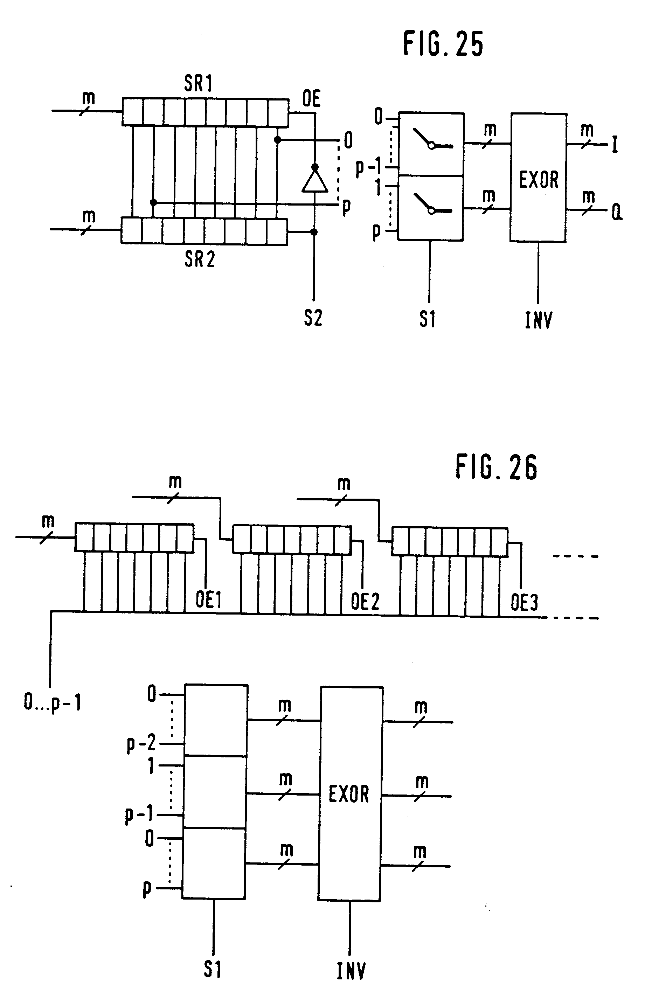

In Fig. 24 ist der Aufbau der Steuerstufe zur Erzeugung der Steuersignale S1, S2 und INV dargestellt. Sie besteht aus einem Zähler Z2, zum Zählen von modulo p, und aus zwei Decodern DEC1 und DEC2. Diesen Decodern wird jeweils das Ausgangssignal des Zählers Z2, also ld p, zugeführt und ein Steuersignal. Für den Decoder DEC1 ist dies das Steuersignal C1 und für den Decoder DEC2 das Steuersignal C2. In diesen Steuersignalen C1 und C2 sind Phaseninformationen enthalten, die für QPSK beispielsweise durch folgende Codierungszuordnungen realisierbar sind:

| C1 | C2 | Phase |
|----|----|-------|
| 0  | 0  | $0°$ |
| 0  | 1  | $90°$ |
| 1  | 0  | $180°$ |
| 1  | 1  | $270°$ |

Die Decoder DEC1 und DEC2 nehmen eine Signalwandlung entsprechend den Signalverläufen in den Figuren 21 bis 23 vor. Sie können durch PROMs, Gatternetze oder PAL-Bausteine realisiert sein. Am Ausgang des Decoders DEC1 erscheint das Steuersignal S2 und am Ausgang des Decoders DEC2 das Signal INV.

Die Schieberegisterbank in Fig. 19 kann gemäß Fig. 25 hardwaremäßig vereinfacht werden durch Benutzung der Tristate-Funktion eines Schieberegisters. Die Parallelausgänge der Schieberegister SR1 und SR2 für jeden Kanal sind miteinander verbunden. Die Ausgangssignale sind über die Schieberegisterparallelverbindungen auf einem parallelen Bus abnehmbar. Die Steuerung der Schieberegister SR1 und SR2 erfolgt über die "output-enable" Eingänge OE - für SR2 mit dem Signal S2 und für SR1 mit dem dazu invertierten Signal. Der sich anschließende Multiplexer MX4 verarbeitet paarweise die Eingangssignale 0 ... p-1 und 1 ... p. Er wird gesteuert vom Signal S1. Das EXOR-Gatter ist wie Fig. 19 ausgeführt. Für m = Anzahl der Soft-Decision Bits und n = Anzahl der PSK-Kanäle sind bei der Realisierung gemäß Fig. 19 beispielsweise folgende Bauelemente nötig:

$m \cdot n \cdot p/8$ Stück 74 AC 299 als Schieberegister,

$m \cdot n^2 \cdot p/16$ Stück 74 LS 450 als Multiplexer
$\qquad$ SM11, SM12;
$\qquad$ SM21, SM22,

$m \cdot n \qquad$ - bei QPSK 2m/4 - Stück 74 AC 257 als Multiplexer MX33
und

$m \cdot n/4$ Stück 74 F 86 als EXOR-Gatter.

Für die Realisierung gemäß Fig. 25 sind folgende Bauelemente nötig:

$m \cdot n \cdot p/8$ Stück 74 AC 299 als Schieberegister,

$n \cdot m \cdot p/16$ Stück 74 LS 450 als Multiplexer
und

$m \cdot n/4$ Stück 74 F 86 als EXOR-Gatter.

Die Multiplexer SM11, SM12; SM21 und SM22 sind ersetzt durch die Bus Funktion (Tristate der Schieberegister).

In Fig. 26 ist die Schieberegisterbank für ein n-PSK Signal dargestellt. Das Ausgangssignal ist wieder über einen parallelen Bus der Breite 0 ...p-1 abnehmbar. Der nachfolgende Dreifach-Multiplexer MX5 und das schaltbare EXOR-Gatter sind wiederum durch die Steuersignale S1 und INV steuerbar.

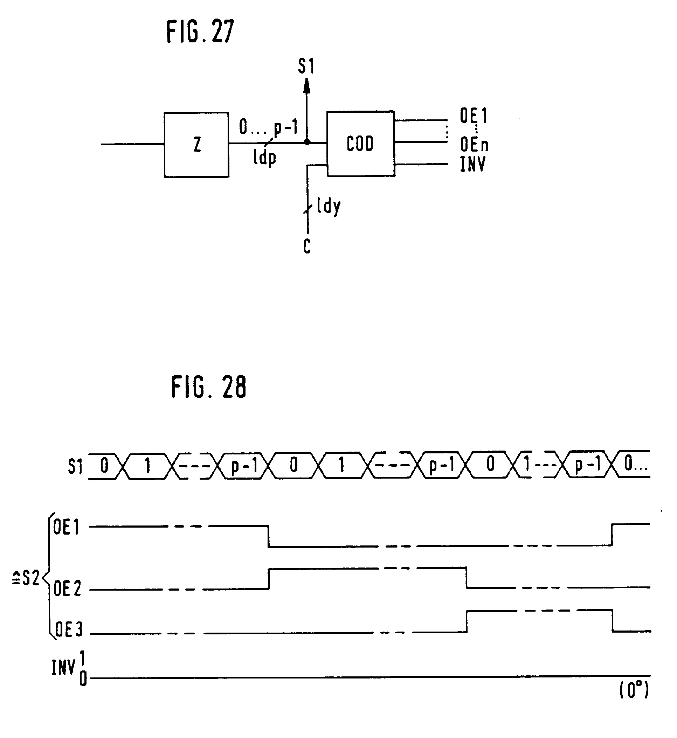

Für jedes Schieberegister ist ein anderes "output-enable" Signal OE1, OE2, ... OEn nötig. Zur Erzeugung der Steuersignale S1, INV und OE1, OE2, ... OEn dient die Steuerstufe gemäß Fig. 27. Ein Coder COD, ausgebildet als PROM oder PAL, gewinnt aus dem Ausgangssignal des modulo P Zählers Z und einem Steuersignal C mit einer Bitlänge von ld y, wobei y die Anzahl der möglichen Phasenvieldeutigkeiten angibt, die output-enable Signale OE1 ... OEn sowie das Steuersignal INV. Die Signalaufbereitung im Coder COD ist aus Fig. 28 ersichtlich, welche den Verlauf der Steuersignale bei n-PSK wiedergibt.

Die Position der Multiplexer MX33, MX4 und MX5 bezüglich der EXOR-Gatter (Fig. 19, 25 und 26) kann vertauscht werden. Dies ist insbesondere dann sinnvoll, wenn gilt:

$$p < m \cdot n$$

mit m = Anzahl der Soft-Decision Bits und n = Anzahl der PSK-Kanäle. Die Anzahl der nötigen Bausteine beträgt dann statt m · n/4 nur p/4 Stück 74 F 86 als EXOR-Gatter.


**Patentansprüche**

1. Verfahren zur Aufbereitung eines Faltungscodes hoher Rate zur Übertragung sowie dessen empfangsseitige Rückwandlung, wobei von einem Faltungs-Encoder n verschiedene Ausgangsbitströme parallel ausgegeben werden, die in untereinander gleichlange Blöcke unterteilt sind, mit n = 2,3 ..., wobei die n jeweils parallel ausgegebenen Blöcke in einem Zeitintervall auftreten, dessen Länge jeweils der zeitlichen Länge der dem Faltungs-Encoder eingangsseitig zugeführten Datenworte entspricht, wobei innerhalb dieser Blöcke in Anwendung einer Code-Punktierung Bits unterdrückt werden und wobei die n verschiedenen Ausgangsbitströme des Faltungs-Encoders seriell jeweils während eines Zeitraumes aneinandergefügt werden, der dem Produkt aus der Anzahl n der verschiedenen Ausgangsbitströme und der Länge des Zeitintervalls entspricht, dadurch gekennzeichnet, daß aus den serialisierten n verschiedenen Ausgangsbitströmen jeweils n Datenworte gebildet werden, welche auf n Übertragungskanäle verteilt und gleichzeitig übertragen werden, daß die Datenworte auf jedem der n Übertragungskanäle jeweils nur Daten enthalten, die aus einem bestimmten Zeitintervall stammen, und daß die empfangsseitige Depunktierung für alle Übertragungskanäle parallel und gleichzeitig vorgenommen wird.

2. Einrichtung zur Aufbereitung eines Faltungscodes hoher Rate, mit einem Faltungs-Encoder dessen n Ausgänge n verschiedene Ausgangsbitströme parallel ausgeben, welche in untereinander gleichlange Blöcke unterteilt sind, mit n = 2, 3, ..., wobei die n jeweils parallel ausgegebenen Blöcke in einem Zeitintervall auftreten, dessen Länge jeweils der zeitlichen Länge der dem Faltungs-Encoder eingangsseitig zugeführten Datenworte entspricht, wobei die n Ausgänge des Faltungs-Encoders jeweils an n Parallel-Eingänge von n parallel geschalteten sendeseitigen Datenumordnern (SFIFO1, SFIFO2, SFIFO3, ..., MX1, MX2, MX3, ...) angeschlossen sind, wobei jeder der n Datenumordner (SFIFO1, SFIFO2, SFIFO3, ..., MX1, MX2, MX3, ...) Mittel zur Parallel-Serien-Wandlung umfaßt, wobei n Übertragungskanäle zur gleichzeitigen Übertragung von n Datenworten vorgesehen sind und jeweils der serielle Ausgang eines der n Datenumordner mit einem der n Übertragungskanäle verbunden ist, wobei den Datenumordnern Steuerschaltkreise so zugeordnet sind, daß die n verschiedenen Ausgangsbitströme des Faltungs-Encoders jeweils während des Zeitintervalls abwechselnd einlesbar und kontinuierlich, d.h. gleichzeitig und parallel, derart auslesbar sind, daß die von jedem Datenumordner aus den n verschiedenen Ausgangsbitströmen des Faltungs-Encoders gebildeten Datenworte auf jedem der n Übertragungskanäle jeweils nur Daten enthalten, die aus einem bestimmten Zeitintervall stammen, daß ein alle n Übertragungskanäle parallel verarbeitender Punktierer (FIFO-P) den Mitteln zur Parallel-Serienwandlung nachgeschaltet ist, wobei empfangsseitig ein alle Übertragungskanäle parallelverarbeitender Depunktierer (FIFO-D) vorgesehen ist, der ausgangsseitig mit einem Multiplexer (MUX-D) zur Einblendung von metrik-neutralen Auffülldaten (Dummy Bits) versehen ist, wobei empfangsseitige Datenumordner (EFIFO1, EFIFO2, ...) zur Serien-Parallelwandlung von Daten vorgesehen sind mit Steuerschaltkreisen zum kontinuierlichen Einlesen und abwechselnden Auslesen der Übertragungsdaten bezüglich jeweils der Dauer eines Blockes und wobei den empfangsseitigen Datenumordnern (EFIFO1, EFIFO2, ...) ein dem Faltungs-Encoder entsprechender Faltungs-Decoder (FD) nachgeschaltet ist.

3. Einrichtung nach Anspruch 2, dadurch gekennzeichnet, daß die sendeseitigen Datenumordner aus elastischen Speichern (SFIFO1, SFIFO2, SFIFO3, ...) bestehen, die parallelseriell-wandelnd ausgebildet sind.

4. Einrichtung nach Anspruch 2, dadurch gekennzeichnet, daß die sendeseitigen Datenumordner aus parallel arbeitenden elastischen Speichern (FIFO1, IFO2, FIFO3, ...) bestehen, und daß jedem elastischen Speicher ein Multiplexer (MX1, MX2, ...) zur Parallel-Serienwandlung nachgeschaltet ist.

5. Einrichtung nach Anspruch 2, dadurch gekennzeichnet, daß die empfangsseitigen Datenumordner aus jeweils einem parallel arbeitenden elastischen Speicher (EFIFO1, EFIFO2, ...) pro Übertragungskanal bestehen, und daß diese elastischen Speicher parallel-seriell-wandelnd ausgebildet sind.

**6.** Einrichtung nach einem der Ansprüche 2 bis 4, dadurch gekennzeichnet, daß die empfangsseitigen Datenumordner aus mindestens je zwei parallel arbeitenden elastischen Speichern (EFIFO1, EFIFO1′, EFOFO2, EFIFO2′, ...) pro Übertragungskanal bestehen, in die die depunktierten Empfangsbitströme für jeden Übertragungskanal abwechselnd einlesbar sind.

**7.** Einrichtung nach einem der Ansprüche 2 bis 4, dadurch gekennzeichnet, daß die empfangsseitigen Datenumordner aus einer Schieberegisterbank (SR) bestehen, in die die depunktierten Daten seriell einlesbar sind, daß zur SeriellParallel-Wandlung Multiplexer (SM11, SM12, ...; SM21, SM 22, ...) vorgesehen sind, die jeweils an die Parallelausgänge der Schieberegisterbank (SR) derart angeschlossen sind, daß die Übertragungsdaten in der ursprünglichen zeitlichen Folge an ihren Ausgängen abnehmbar sind.

**8.** Einrichtung nach Anspruch 7, dadurch gekennzeichnet, daß die Multiplexer (SM11, SM12, ...; SM21, SM 22, ...) n-stufig aufgebaut sind, daß eine Steuerschaltung vorgesehen ist, mittels derer die Multiplexer bei der Auswahl der Registerzellen der Schieberegisterbank (SR) in gegensinniger Orientierung und bezüglich der Parallelausgänge der Schieberegisterbank (SR) um den Takt für eine Registerzelle versetzt steuerbar sind derart, daß aus zeitlich aufeinanderfolgenden Bits beim Auslesen Dibits entstehen.

**9.** Einrichtung nach Anspruch 7, dadurch gekennzeichnet, daß zur Serien-Parallelwandlung anstelle der Multiplexer ein paralleler Bus (BU) vorgesehen ist zur Zusammenfassung der Parallelausgänge der Schieberegisterbank (SR).

**10.** Einrichtung nach Anspruch 2, dadurch gekennzeichnet, daß dem Depunktierer (FIFO-D) eine Kanalvertauschungsstufe zur Phasenfehlerkorrektur nachgeschaltet ist.

**11.** Einrichtung nach Anspruch 10, dadurch gekennzeichnet, daß die Kanalvertauschungsstufe (KV) aus einer über ein Steuersignal aktivierbaren logischen EXOR-Verknüpfungsstufe besteht.

**12.** Einrichtung nach Anspruch 10 oder 11, dadurch gekennzeichnet, daß zwischen den Depunktierer (FIFO-D) und die Kanalvertauschungsstufe (KV) die empfangsseitigen Datenumordner (EFIFO1, EFIFO2, ...) eingefügt sind.

**13.** Einrichtung nach Anspruch 2 oder 10, dadurch gekennzeichnet, daß den empfangsseitigen Datenumordnern (EFIFO1, EFIFO2, ...; SR) Mittel (EXOR) zur Signalinvertierung für eine Phasenfehlerkorrektur nachgeschaltet sind.

## Claims

**1.** A method for editing a high-rate convolutional code for transmission and its reconversion, wherein different output bit streams are transmitted parallel by a convolutional encoder and distributed into blocks which differ in length among themselves, having n = 2, 3, ... , wherein the n parallel transmitted blocks appear in one time interval whose length respectively corresponds to the temporal length of the data words fed to the convolutional encoder at the input, wherein bits inside these blocks are suppressed in the use of code-puncturing, and wherein the n different output bit streams of the convolutional encoder are serially added during one time interval, which corresponds to the product of the number n of the different output bit streams and the length of the time interval, characterized in that, from the serialized n different output bit streams, respectively n-data words are formed which are distributed to n-transmission channels and simultaneously transmitted, that the data words on each of the n-transmission channels respectively contain only data originating in a certain time interval, and in that the de-puncturing at the receiver is performed parallel and simultaneously for all channels.

**2.** A device for processing a convolutional code having a high rate, having a convolutional encoder whose n-inputs transmit n different output bit streams parallel, which streams are distributed into blocks of equal length among themselves, having n = 2, 3, ..., wherein the n parallel transmitted blocks appear in one time interval whose length respectively corresponds to the temporal length of the data words fed to the convolutional encoder at the input, wherein the n-outputs of the convolutional encoder are each connected to n parallel inputs of n parallel switched data rearrangers at the transmitter (SFIFO1, SFIFO2, SFIFO3, ...), wherein each of the n-data rearrangers (SFIFO1, SFIFO2, SFIFO3) encompasses means for parallel/serial conversion, wherein n-transmission channels are provided for simultaneous transmission of n-data words, and respectively the serial input of one of the n-data rearrangers is connected to one of the n-transmission channels, wherein control switching circuits are assigned to the data rearrangers in such a way that the n different output bit streams of the convolutional encoder can be alternately read in and read out continuously during the time interval, i.e. simultaneously and in parallel, that the data words formed by each data rearranger from the n different output data streams of the convolutional encoder on each of the n-transmission channels respectively contain only data originating in a certain time interval, that a puncturer (FIFO-P), processing all n transmission channels in parallel, is provided downstream of the means for parallel/serial conversion, wherein at the receiver a de-puncturer (FIFO-D), processing all transmission channels in parallel, is provided, which at the output is equipped with a multiplexer (MUX-D) for inserting metric-neutral filler data (dummy bits), wherein at the receiver data rearrangers (EFIFO1, EFIFO2, ...) for serial/parallel conversion of data are provided, having control switching circuits for the continuous read-in and alternate read-out of the transmitted data in regard to the length of a period, and wherein a convolutional decoder (FD), corresponding to the convolutional encoder (FE), is disposed downstream from the data rearrangers (EFIFO1, EFIFO2, ...) at the receiver.

3. A device in accordance with claim 2, characterized in that the data rearrangers at the transmitter comprise elastic memories (SFIFO1, SFIFO2, SFIFO3, ...) configured to be parallel/serial converters.

4. A device in accordance with claim 2, characterized in that the data rearrangers at the transmitter comprise parallel-acting elastic memories (FIFO1, FIFO2, FIFO3, ...) and that a multiplexer (MX1, MX2, ...) for parallel/serial conversion is disposed downstream from each elastic memory.

5. A device in accordance with claim 2, characterized in that the data rearrangers at the receiver each comprise a parallel-acting elastic memory (EFIFO1, EFIFO2, ...) per transmission channel, and that these elastic memories are configured as parallel/serial converters.

6. A device in accordance with one of claims 2 to 4, characterized in that the data rearrangers at the receiver comprise at least respectively two parallel-acting elastic memories (EFIFO1, EFIFO1′, EFIFO2, EFIFO2′, ...) per transmission channel into which the de-punctured received bit streams can be read alternately for each channel.

7. A device in accordance with one of claims 2 to 4, characterized in that the data rearrangers at the receiver comprise a shift register bank (SR) into which the de-punctured data can be serially read, that multiplexers (SM11, SM12, ...; SM21, SM22...... ) for serial/parallel conversion are provided which are each connected to the parallel outputs of the shift register bank (SR) in such a way that the transmitted data can be read at their outputs in the original time sequence.

8. A device in accordance with claim 7, characterized in that the multiplexers (SM11, SM12, ..., SM21, SM22, ...) are designed with n stages, that a control circuit is provided, by means of which the multiplexers, in the selection of the register cells of the shift register back (SR), can be controlled in opposite directions and, with respect to the parallel outputs of the shift register bank (SR), offset by the clock for one register cell such that during read-out dibits are created from time-sequential bits.

9. A device in accordance with claim 7, characterized in that, instead of the multiplexers, a parallel bus (BU) is provided for the serial/parallel conversion in order to combine the parallel outputs of the shift register bank (SR)-

10. A device in accordance with claim 2, characterized in that a channel transposition stage for the correction of phase ambiguities is disposed downstream of the de-puncturer (FIFO-D).

11. A device in accordance with claim 10, characterized in that the channel transposition stage (KV) comprises a logical exclusive OR linking stage which can be activated via a control signal.

12. A device in accordance with claim 10 or 11, characterized in that the data rearrangers (EFIFO1, EFIFO2, ... ) at the receiver are inserted between the de-puncturer (FIFO-D) and the channel transposition stage (KV).

13. A device in accordance with claim 2 or 10, characterized in that means (exclusive OR) for inverting the signal for a phase ambiguity correction are disposed downstream of the data rearrangers (EFIFO1, EFIFO2, ...; SR) at the receiver.

9

**Revendications**

1. Procédé pour la préparation d'un code de convolution à rapport de proportion élevé, pour la transmission ainsi que sa transformation inverse côté réception, n courants de bits de sortie différents étant émis en parallèle par un encodeur de convolution, qui sont subdivisés en des blocs de même longueur les uns les autres, avec n = 2, 3 ..., les n blocs émis chaque fois en parallèle, apparaissant dans un intervalle de temps dont la longueur, chaque fois, correspond à la longueur dans le temps du mot de données amené côté entrée à l'encodeur de convolution, des bits étant supprimés à l'intérieur de ces codes dans l'emploi d'une ponctuation de code, et les n courants de données de sortie différents de l'encodeur de convolution étant chaque fois joints les uns aux autres en série pendant un laps de temps, qui correspond au produit du nombre n des différents courants de bits de sortie et de la longueur de l'intervalle de temps, caractérisé en ce qu'à partir des n courants de bits de sortie différents mis en série, chaque fois, n mots de données sont formés, lesquels sont répartis sur n canaux de transmission et transmis en même temps, en ce que les mots de données sur chacun des n canaux de transmission, chaque fois, contiennent seulement des données, qui ont pour origine un intervalle de temps déterminé, et en ce que la déponctuation côté réception est effectuée pour tous les canaux de transmission, en parallèle et en même temps.

2. Dispositif pour la préparation d'un code de convolution à rapport de proportion élevé, avec un encodeur de convolution, dont n sorties émettent en parallèle n courants de bits de sortie différents, lesquels sont subdivisés en des blocs de même longueur les uns les autres, avec n = 2, 3, ..., les n blocs, émis en parallèle chaque fois, apparaissant dans un intervalle de temps, dont la longueur, chaque fois, correspond à la longueur dans le temps des mots de données amenés côté entrée à l'encodeur de convolution, les n sorties de l'encodeur de convolution étant raccordées, chaque fois, à n entrées parallèles de n réordonnateurs de données (SFIFO1, SFIFO2, SFIFO3, ..., MX1, MX2, MX3, ...) mis en circuit en parallèle côté émission, chacun des n réordonnateurs de données (SFIFO1, SFIFO2, SFIFO3, ..., MX1, MX2, MX3, ...) comprenant des moyens pour la conversion parallèle-série, n canaux de transmission, pour la transmission en même temps de n mots de données, étant prévus, et, chaque fois, la sortie en série d'un des n réordonnateurs de données étant reliée avec un des n canaux de transmission, des circuits de commutation de commande étant ainsi associés aux réordonnateurs de données, que les n courants de bits de sortie différents de l'encodeur de convolution, chaque fois, pendant l'intervalle de temps, sont alternativement susceptibles d'être mis en mémoire et de façon continue, c'est-à-dire en même temps et en parallèle, sont susceptibles d'être extraits de telle sorte, que les mots de données formés par chaque réordonnateur de données, à partir des n courants de bits de sortie différents de l'encodeur de convolution, sur chacun des n canaux de transmission, chaque fois, contiennent seulement des données, qui ont pour origine un intervalle de temps déterminé, en ce qu'un dispositif de ponctuation (FIFO-P) traitant en parallèle tous les n canaux de transmission est mis en circuit en aval des moyens pour la conversion parallèle-série, côté sortie, un dispositif de déponctuation (FIFO-D) traitant en parallèle tous les canaux de transmission étant prévu, qui, côté sortie, est pourvu d'un multiplexeur (MUX-D) pour l'introduction de données de remplissage (Dummy Bits) neutres au point de vue métrique, des réordonnateurs de données (EFIFO1, EFIFO2, ...) étant prévus côté réception, pour la conversion série-parallèle de données, avec des circuits de commutation de commande pour la mise en mémoire et, alternativement, l'extraction des données de transmission en continu, par rapport, chaque fois, à la durée d'un bloc, et un décodeur de convolution (FD) correspondant à l'encodeur de convolution étant mis en circuit en aval des réordonnateurs de données (EFIFO1, EFIFO2, ...) coté réception.

3. Dispositif selon la revendication 2, caractérisé en ce que les réordonnateurs de données côté émission consistent en des mémoires (SFIFO1, SFIFO2, SFIFO3, ...) élastiques, qui sont constituées en se combinant en parallèle et en série.

4. Dispositif selon la revendication 2, caractérisé en ce que les réordonnateurs de données côté émission consistent en des mémoires ((FIFO1, FIFO2, FIFO3, ...) élastiques travaillant en parallèle, et qu'à chaque mémoire élastique, est mis en circuit en aval un multiplexeur (MX1, MX2, ...) pour la conversion parallèle-série.

5. Dispositif selon la revendication 2, caractérisé en ce que les réordonnateurs de données coté réception consistent, chaque fois, en une mémoire (EFIFO1, EFIFO2, ...) élastique travaillant en parallèle par canal de transmission, et en ce que ces mémoires élastiques sont constituées en se combinant en parallèle et en série.

**6.** Dispositif selon une des revendications 2 à 4, caractérisé en ce que les réordonnateurs de données côté réception consistent au moins, chacun, en deux mémoires (EFIFO1, EFIFO1', EFOFO2, EFIFO2', ...) élastiques travaillant en parallèle par canal de transmission, dans lesquelles, les courants de bits de réception déponctués, pour chaque canal de transmission, sont introduisibles alternativement.

**7.** Dispositif selon une des revendications 2 à 4, caractérisé en ce que les réordonnateurs de données côté réception consistent en une banque de registres à décalage (SR), dans laquelle, les données déponctuées sont introduisibles en série, en ce que pour la conversion série-parallèle, des multiplexeurs (SM11, SM12, ... ; SM21, SM22, ...) sont prévus, qui, chaque fois, sont raccordés aux sorties parallèles de la banque de registres à décalage (SR) de telle sorte, que les données de transmission sont prélevables, dans la suite dans le temps d'origine, à leurs sorties.

**8.** Dispositif selon la revendication 7, caractérisé en ce que les multiplexeurs (SM11, SM12, ... ; SM21, SM22, ...) sont constitués à n étages, en ce qu'un circuit de commande est prévu, au moyen duquel, les multiplexeurs, lors de la sélection des cellules de registre de la banque de registres à décalage (SR), sont susceptibles d'être commandés, en des orientations en sens opposé et, en ce qui concerne les sorties parallèles de la banque de registres à décalage (SR), décalés du cycle pour une cellule de registre, de telle sorte, qu'à partir de bits se suivant les uns aux autres dans le temps, lors de l'extraction, desdits bits prennent naissance.

**9.** Dispositif selon la revendication 7, caractérisé en ce que pour la conversion série-parallèle, à la place des multiplexeurs, un conducteur omnibus (BU) parallèle est prévu, pour le groupement des sorties parallèles de la banque de registres à décalage (SR).

**10.** Dispositif selon la revendication 2, caractérisé en ce qu'au dispositif de déponctuation (FIFO-D), un étage de permutation de canal, pour la correction de défaut de phase, est mis en circuit en aval.

**11.** Dispositif selon la revendication 10, caractérisé en ce que l'étage de permutation de canal (KV) consiste en un étage d'enchaînement EXOR logique, susceptible d'être activé par un signal de commande.

**12.** Dispositif selon la revendication 10 ou la revendication 11, caractérisé en ce qu'entre le dispositif de déponctuation (FIFO-D) et l'étage de permutation de canal (KV), les réordonnateurs de données (EFIFO1, EFIFO2, ...) côté réception sont insérés.

**13.** Dispositif selon la revendication 2 ou la revendication 10, caractérisé en ce qu'aux réordonnateurs de données (EFIFO1, EFIFO2, ... ; SR) côté réception, des moyens (EXOR), pour l'inversion de signal pour une correction de défaut de phase, sont mis en circuit en aval.

## FIG.2

$$a_1$$

I → Reg

$$a_2$$

## FIG.1

$$a_1^1 \, a_1^2 \, a_1^3 ...$$

$$a_2^1 \, a_2^2 \, a_2^3 ...$$

| 1 | 1 |
|---|---|
| 1 | 0 |

Pu

$$a_1^1 \, a_1^2 \, a_1^3 ...$$

$$a_2^1 \, a_2^3 \, a_2^5 ...$$

$$a_1$$

$$a_2$$

$$a_1^1 \, a_1^2 \, a_1^3 \, a_1^4 \, a_1^{1'}$$

$$a_2^1 \, a_2^2 \, a_2^3 \, a_2^4 \, a_2^{1'}$$

$$a_1^1 \, a_2^1 \, a_1^2 \, a_1^3 \, a_1^4$$

Q PSK

$$a_1^1 \, a_1^2 \, a_1^4 \, a_2^{1'} \, a_1^{3'} \, a_1^1$$

$$a_2^1 \, a_1^3 \, a_1^{1'} \, a_1^{2'} \, a_1^{4'}$$

$$\begin{vmatrix} 1 & 1 & 1 & 1 \\ 1 & 0 & 0 & 0 \end{vmatrix} \begin{vmatrix} 1 \\ 1 \end{vmatrix} \; \cdots$$

Punktiervorschrift

## FIG.3

$$a_1^1 \, a_1^3 \, a_2^{1'} \, a_1^{4'} \, a_1^{2''} \, a_1^{1'''}$$

$$a_2^1 \, a_1^4 \, a_1^{2'} \, a_1^{1''} \, a_1^{3''}$$

8-PSK $$a_1^2 \, a_1^{1'} \, a_1^{3'} a_2^{1''} \, a_1^{4''}$$

FIG. 4

a PSK

8 - PSK

FIG. 5

Dummy

Dibits für
Decoder

FIG. 6

Dibits für
Decoder

EP 0 301 161 B1

## FIG. 7

## FIG.8

## FIG.9

FIG. 10

FIG. 11

FIG. 12

FIG. 13

FIG. 14

FIG. 15

## FIG.16

OE1

$Q_2 Q_1$ — EFIFO1 — $Q_1 (Q_1')$

$Q_2 (Q_2')$

OE2

$Q_2' Q_1'$ — EFIFO2

CLK        t2    t1

## FIG.17

OE1

$Q_2 Q_1$ — EFIFO1 — $Q_1 (Q_1')$

OE1

EFIFO1' — $Q_2 (Q_2')$

OE2

$Q_2' Q_1'$ — EFIFO2

OE2

EFIFO2'

INV

CLK/2      t2    t1

## FIG.18

CLK → Z1

OE2  OE1

DEC — & — t1

& — t2

CLK

FIG. 19

SM11    SM12

$$p-1 \quad 0 \quad p-1 \quad 0$$

$$p \quad | \quad | \quad | \quad 1 \quad p-1 \quad | \quad | \quad | \quad 0$$

$$p \quad - \quad - \quad - \quad 1 \quad 0$$

m

SM21    SM22

$$p-1 \quad 0 \quad p-1 \quad 0$$

$$p \quad - \quad - \quad 1 \quad p-1 \quad - \quad - \quad 0$$

$$p \quad - \quad - \quad - \quad 1 \quad 0$$

m

SR

m

m

m

m

MX33

EXOR

I

Q

m

m

m

m

m

1

INV

ldp    ldn

St

FIG. 20

$$a_1^{1'} \quad a_2^{1'} \quad a_1^{2'}x a_1^{3'}x a_1^{4'}x$$

$$a_1^{1} \quad a_2^{1} \quad a_1^{2}x a_1^{3}x a_1^{4}x$$

KV

$$a_1^{1} \quad a_2^{1} \quad a_1^{2}x a_1^{3}x a_1^{4}x$$

$$a_1^{1'} \quad a_2^{1'} \quad a_1^{2'}x a_1^{3'}x a_1^{4'}x$$

Decoder - Dibits

## FIG. 21

Phase 0° ; 180°

S1 ──╳── 0 ──╳── 1 ──╳─ - - -╳─ p-2 ╳ p-1 ╳── 0 ──╳── 1 ──╳─ - -╳ p-1 ╳── 0 ──╳── 1 ──╳ - - -

S2

INV ──────────────────────────────────────────────── 180°
──────────────────────────────────────────────── 0°

## FIG. 22

Phase 90°

S1 ──╳── 0 ──╳── 1 ──╳─ - -╳─ p-2 ╳ p-1 ╳── 0 ──╳── 1 ──╳─ - -╳ p-1 ╳── 0 ──╳ - - -

S2

INV

## FIG. 23

Phase - 90°

S1 ──╳── 0 ──╳── 1 ──╳─ - -╳─ p-2 ╳ p-1 ╳── 0 ──╳── 1 ──╳─ - -╳ p-1 ╳── 0 ──╳ - - -

S2

INV

## FIG. 24

# FIG. 25

# FIG. 26

FIG. 27

FIG. 28